Europäisches Patentamt

European Patent Office

Office européen des brevets

(19)

(11) **EP 0 503 416 B1**

(12)

# FASCICULE DE BREVET EUROPEEN

(45) Date de publication et mention
de la délivrance du brevet:
**23.07.1997 Bulletin 1997/30**

(51) Int Cl.⁶: **H03D 3/24**, H03L 7/107

(21) Numéro de dépôt: **92103530.9**

(22) Date de dépôt: **02.03.1992**

(54) **Démodulateur à boucle de phase**

Demodulator mit Phasenregelschleife

Phase locked loop demodulator

(84) Etats contractants désignés:
**CH DE ES FR GB IT LI**

(30) Priorité: **08.03.1991 FR 9102817**

(43) Date de publication de la demande:
**16.09.1992 Bulletin 1992/38**

(73) Titulaires:
- ALCATEL ESPACE
  **F-92407 Courbevoie Cédex (FR)**
  Etats contractants désignés:
  **DE ES FR GB IT**
- ALCATEL N.V.
  **NL-1077 XX Amsterdam (NL)**
  Etats contractants désignés:
  **CH LI**

(72) Inventeurs:
- **Tonello, Emile**
  **F-31100 Toulouse (FR)**
- **Herbere, Christian**
  **F-31830 Plaisance du Touch (FR)**

(74) Mandataire: **Weinmiller, Jürgen et al**
**Postfach 24**
**82336 Feldafing (DE)**

(56) Documents cités:
**EP-A- 0 432 683** **GB-A- 1 307 888**
**US-A- 3 983 501** **US-A- 4 937 536**

- **PATENT ABSTRACTS OF JAPAN vol. 010, no. 150 (E-408) 31 Mai 1986 & JP-A-61 009 021 (SONY KK) 16 jann. 1986**
- **PATENT ABSTRACTS OF JAPAN vol. 7, no. 182 (E-192)(1327) 11 Août 1983 & JP-A-58 087 902 (MITSUBISHI DENKI K.K)**
- **PATENT ABSTRACTS OF JAPAN vol. 005, no. 133 (E-071) 25 Août 1981 & JP-A-56 069 934 (PIONEER ELECTRONIC CORP:)**
- **IEEE TRANSACTIONS ON AEROSPACE AND ELECTRONIC SYSTEMS. vol. AES12, no. 5, Septembre 1976, NEW YORK US pages 628 - 638; A. BLANCHARD: 'Phase-Locked Loop Behavior Near Threshold'**

**Description**

L'invention concerne un démodulateur à boucle de phase.

Le document D1 = patent abstracts of Japan, vol. 10, no. 150, (E-408), 31 mai 1986, & JP A 61 009021, concerne un récepteur radio FM qui utilise une boucle de phase pour stabiliser la fréquence de réception sur un canal donné. Ce document décrit un démodulateur à boucle de phase comportant un filtre de boucle et un VCO, ledit filtre de boucle comprenant un amplificateur pour fournir un gain de boucle et un commutateur commandable, ledit commutateur permettant de modifier ledit gain de boucle en jouant sur les caracteristiques dudit filtre. Selon l'enseignement de ce document, le commutateur permet d'obtenir une baisse du gain statique de boucle quand la largeur du filtre est diminuée lors de l'acquisition d'un canal à la fréquence de réception.

Le manuel de Floyd Gardner intitulé "Phaselock techniques" (deuxième édition : pages 182-183) décrit un démodulateur à boucle de phase de l'art connu qui comprend un filtre passe-bande d'entrée, une boucle de phase comportant un détecteur de phase, un filtre de boucle, un VCO ("Voltage Controlled Oscillator"); un filtre de désaccentuation étant disposé en sortie de la boucle de phase.

Dans une telle boucle de phase, tout décalage entre la fréquence de la porteuse à démoduler (Fe) et la fréquence de repos du VCO $(F_{vco})_o$ (ce décalage peut être dû à un vieillissement du VCO, une dérive de la porteuse...) produit une erreur de phase statique en sortie du comparateur de phase de la boucle, ce qui traduit par :

- une dégradation du seuil du démodulateur;
- une plus grande sensibilité au phénomène de "clicks".

En effet, les comparateurs de phase sont des dispositifs non linéaires et leur fonctionnement optimum correspond à une utilisation à erreur de phase statique nulle.

L'erreur de phase statique dûe à un écart de fréquence entre Fe et $(F_{VCO})_o$ est donnée par :

$$\Delta\varphi = \frac{F_e - (F_{VCO})_o}{K_T}$$

La valeur de $K_T$ étant limitée par :

- la difficulté de réaliser des amplificateurs grand gain-large bande;
- les sensibilités respectives du comparateur de phase et du VCO;
- les offsets et dérives générés par les amplicateurs.

L'inconvénient majeur d'une telle boucle est la très forte sensibilité des performances aux erreurs de phase statiques, ces erreurs de phase statiques, dues aux dérives de certaines composants d'un système de réception, dégradant alors très fortement le seuil du démodulateur.

L'invention a pour objet de pallier de tels inconvénients.

Elle propose, à cet effet, un démodulateur à boucle de phase comprenant entre son entrée et sa sortie : un filtre de boucle et un VCO, ledit filtre de boucle comprenant un amplificateur pour fournir un gain de boucle et au moins un commutateur commandable, ledit commutateur permettant de modifier ledit gain de boucle en jouant sur les caractéristiques dudit filtre, caractérisé en ce que ledit démodulateur comprend en outre au moins un mélangeur et un circuit de détection de l'accrochage, ledit circuit de détection fournissant un signal de sortie audit commutateur commandable de manière à augmenter le gain de boucle en jouant sur les caractéristiques dudit filtre quand l'accrochage est détecté.

Dans une première réalisation avantageuse le filtre de boucle est réalisé par un amplificateur de gain infini dont une entrée est reliée à la masse et l'autre entrée est reliée à la sortie du mélangeur à travers une résistance, un réseau R,C étant disposé entre cette seconde entrée et la sortie de l'amplificateur.

Dans une seconde réalisation avantageuse le mélangeur possède deux sorties différentielles, et le filtre de boucle est réalisé par un amplificateur de gain infini dont les entrées sont reliées aux sorties du mélangeur à travers deux résistances; deux réseaux étant disposés l'un entre la première entrée et la masse et l'autre entre la seconde entrée et la sortie de l'amplificateur.

Chaque réseau comporte sur trois branches parallèles :

- une première résistance de valeur Ra;
- une deuxieme résistance de valeur Rb en série avec une capacité,
- une troisième résistance de valeur Rc en série avec un interrupteur commandable électriquement qui reçoit, comme signal de commande, le signal de sortie du circuit de détection de l'accrochage;

- avec pour chaque réseau, Ra >> Rc >> Rb.

Le circuit de détection de l'accrochage comprend un premier coupleur au signal d'entrée, un second coupleur au signal de boucle en sortie du VCO, les deux coupleurs étant respectivement reliés directement et au travers d'un déphaseur r/2 à un mélangeur dont la sortie délivre un signal de verrouillage.

Un tel démodulateur présente de nombreux avantages et notamment :

* une grande rapidité de correction des erreurs de phase;
* aucune limitation en fréquence basse en démodulation;
* une grande simplicité de mise en oeuvre (aucun réglage).

Les caractéristiques et avantages de l'invention ressortiront d'ailleurs de la description qui va suivre, à titre d'exemple non limitatif, en référence aux figures annexées sur lesquelles :

- la figure 1 illustre une première réalisation du démodulateur selon l'invention :
- la figure 2 illustre une seconde réalisation du démodulateur selon l'invention.

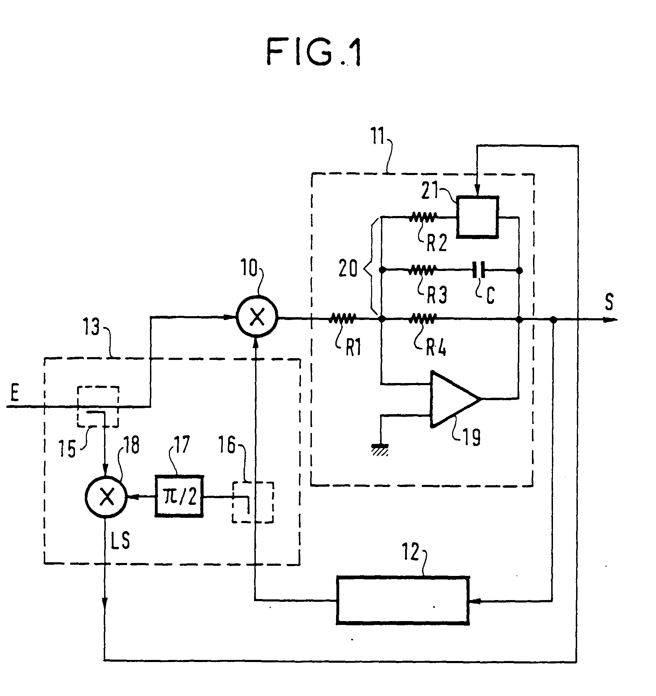

Le démodulateur à boucle de phase de l'invention, tel que représenté sur la figure 1 comprend classiquement entre son entrée E et sa sortie S :

- un mélangeur 10;
- un filtre de boucle 11;

Un VCO 12 ("Voltage Controlled Oscillator") étant connecté entre la sortie S et une entrée du mélangeur.

Mais ce démodulateur comporte de plus un circuit de détection de l'accrochage 13 qui comprend un premier coupleur 15 au signal d'entrée, un second coupleur 16 au signal de boucle en sortie du VCO, ces deux coupleurs 15 et 16 étant respectivement reliés directement et au travers d'un déphaseur $\pi/2$ (17) à un mélangeur 18 dont la sortie délivre un signal de verrouillage LS.

Dans ce démodulateur, le filtre de boucle est réalisé par un amplificateur 19 de gain infini dont une entrée est reliée à la masse et l'autre entrée est reliée à la sortie du mélangeur 10 à travers une résistance R1, un réseau R,C 20 étant disposé entre cette seconde entrée et la sortie de l'amplificateur.

Ce réseau comporte sur trois branches parallèles :

- une résistance R4;
- une résistance R3 en série avec une capacité C;
- une résistance R2 en série avec un interrupteur 21 commandable électriquement qui reçoit, comme signal de commande, le signal de verrouillage LS;

  avec R4 >> R2 >> R3

Un tel démodulateur permet une augmentation, après accrochage du démodulateur, du gain statique sans modification majeure des paramètres de boucle (bande de boucle et coefficient d'amortissement).

Ce démodulateur a, en effet, le fonctionnement suivant :

- Avant accrochage l'interrupteur 21 est fermé car l'indication de verrouillage LS n'est pas valide.

La boucle (10, 11, 12) est en équilibre et ses paramètres de boucle sont :

. Gain statique

$$K_{To} \simeq K_v k_\phi \left( \frac{R_2}{R_1} \right)$$

Fréquence de boucle :

3

$$f_n = \frac{1}{2\pi}\left(\frac{K_\phi K_v}{R2C} \times \frac{R2}{R1}\right)^{1/2} = \frac{1}{2\pi}\left(\frac{K_v K_\phi}{R1C}\right)^{1/2}$$

. coefficient d'amortissement :

$$\xi = \pi f_n \frac{2}{\dot{}}_2 = \frac{1}{2}\left(\frac{K_v K_\phi}{R1C}\right)^{1/2} R3C$$

On voit que la valeur des paramètres $f_n$ et $\xi$ ne dépend que de $K_v$, $K_\phi$, R1, R3 et C.
l'erreur de phase (sans action de l'interrupteur 21) est :

$$\Delta\varphi_o = \frac{\Delta F}{KT_o} = \frac{\Delta F}{K_v k_\phi R2/R1}$$

- Quand la boucle de phase est accrochée sur une porteuse d'entrée, le signal de verrouillage LS valide l'ouverture de l'interrupteur 21.

Comme défini précédemment les valeurs $f_n$ et $\xi$ restent inchangés Par contre $K_T$ devient

$$KT_a = K_v \times K_\phi \left(\frac{R4}{R1}\right)$$

et

$$\Delta\varphi_a = \frac{\Delta F}{K_v K_\phi R4/R1}$$

Le terme correctif de l'erreur de phase est environ $\frac{R4}{R2}$.
A titre d'exemple on peut réaliser ainsi une commutation de gain de l'ordre de 100.
Une telle commutation du gain statique est rendue nécessaire car la valeur maximale du gain en mode attente est limitée par :

. la difficulté de réaliser des amplificateurs à grand gain et à offset nul;
. les dérives du comparateur de phase et du VCO;
. la limitation de la bande d'acquisition;
. la garantie du démarrage du VCO à une fréquence voisine de la fréquence d'entrée.

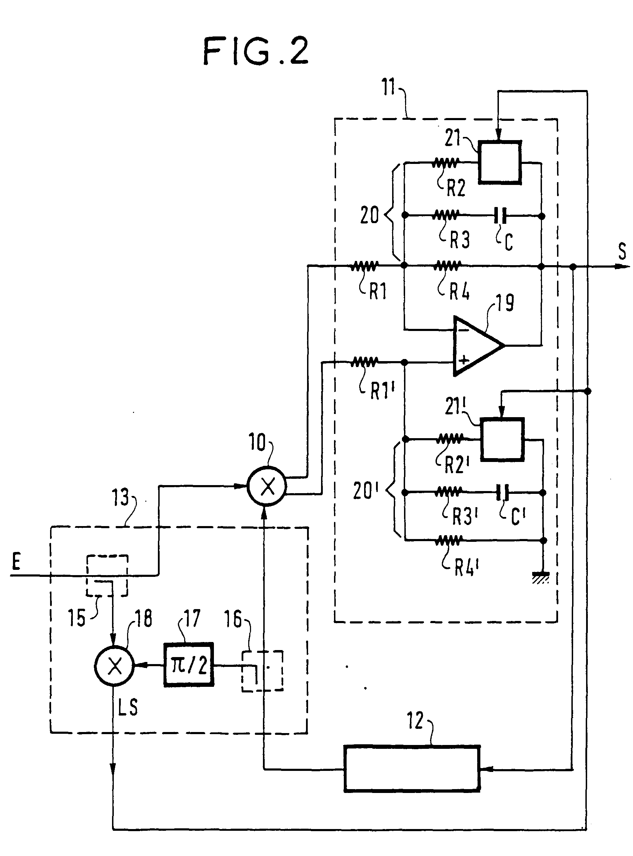

Il est bien entendu que la présente invention n'a été décrite et représentée qu'à titre d'exemple préférentiel et que l'on pourra remplacer ses éléments constitutifs par des éléments équivalents sans, pour autant, sortir du cadre de l'invention.
Ainsi dans le démodulateur selon l'invention, représenté sur la figure 2, le mélangeur 10 possède deux sorties différentielles. Le filtre de boucle 11 est réalisé par un amplificateur de gain infini dont les entrées sont reliées respectivement aux sorties du mélangeur (10) à travers deux résistances R1, et R1'; deux réseaux 20, et 20' étant disposés l'un entre la première entrée et la masse et l'autre entre la seconde entrée et la sortie de l'amplificateur avec R4 >> R2 >> R3 et R4' >> R2' >> R3'.

**Revendications**

1. Démodulateur à boucle de phase comportant un filtre de boucle (11) et un VCO (12), ledit filtre de boucle comprenant un amplificateur (19) pour fournir un gain de boucle et au moins un commutateur commandable (21), ledit commutateur (21) permettant de modifier ledit gain de boucle en jouant sur les caracteristiques dudit filtre (11), **<u>caractérisé en ce que</u>** ledit démodulateur comprend en outre au moins un mélangeur (10) et un circuit de détection de l'accrochage (13), ledit circuit de détection fournissant un signal de sortie (LS) audit commutateur commandable (21) de manière à augmenter le gain de boucle en jouant sur les caractéristiques dudit filtre (11) quand l'accrochage est détecté.

2. Démodulateur selon la revendication 1, caractérisé en ce que le filtre de boucle (11) est réalisé par un amplificateur (19) de gain infini dont une entrée est reliée à la masse et l'autre entrée est reliée à la sortie du mélangeur (10) à travers une résistance (R1), un réseau R,C (20) étant disposé entre cette seconde entrée et la sortie de l'amplificateur.

3. Démodulateur selon la revendication 1, caractérisé en ce que le mélangeur (10) possède deux sorties différentielles, et en ce que le filtre de boucle (11) est réalisé par un amplificateur de gain infini dont les entrées sont reliées aux sorties du mélangeur (10) à travers deux résistances (R1, RI'); deux réseaux (20, 20') étant disposés l'un entre la première entrée et la masse et l'autre entre la seconde entrée et la sortie de l'amplificateur.

4. Démodulateur selon l'une quelconque des revendications 2 ou 3, caractérisé en ce que chaque réseau (20, 20') comporte sur trois branches parallèles:

   - une première résistance de valeur Ra (R4, R4');
   - une deuxième résistance de valeur Rb (R3, R3') en série avec une capacité (C, C'),
   - une troisième résistance de valeur Rc (R2, R2') en série avec un interrupteur (21, 21') commandable électriquement qui reçoit, comme signal de commande, le signal de sortie (LS) du circuit de détection de l'accrochage (13);
   - avec pour chaque réseau, Ra >> Rc >> Rb.

5. Démodulateur selon la revendication 1, caractérisé en ce que le circuit de détection de l'accrochage (13) comprend un premier coupleur (15) au signal d'entrée, un second coupleur (16) au signal de boucle en sortie du VCO (12), ces deux coupleurs (15, 16) étant respectivement reliés directement et au travers d'un déphaseur $\pi/2$ (17) à un mélangeur (18) dont la sortie délivre un signal de verrouillage (LS).

**Patentansprüche**

1. Demodulator mit einer Phasenregelschleife, die ein Schleifenfilter (11) und ein VCO (12) aufweist, wobei das Schleifenfilter einen Verstärker (19), um eine Schleifenverstärkung zu liefern, und mindestens einen steuerbaren Schalter (21) besitzt, mit dem man die Schleifenverstärkung verändern kann, indem man auf die Eigenschaften des Filters (11) einwirkt, dadurch gekennzeichnet, daß der Demodulator außerdem mindestens eine Mischstufe (10) und eine Erfassungsschaltung (13) für das Einrasten des VCO aufweist, wobei die Erfassungsschaltung ein Ausgangssignal (LS) an den steuerbaren Schalter (21) liefert, um die Schleifenverstärkung zu erhöhen, indem auf die Eigenschaften des Filters (11) eingewirkt wird, wenn das Einrasten erfaßt wurde.

2. Demodulator nach Anspruch 1, dadurch gekennzeichnet, daß das Schleifenfilter (11) von einem Verstärker (19) mit unendlich hoher Verstärkung gebildet wird, dessen einer Eingang mit Masse und dessen anderer Eingang mit dem Ausgang der Mischstufe (10) über einen Widerstand (R1) verbunden ist, wobei ein RC-Glied (20) zwischen diesem zweiten Eingang und dem Ausgang des Verstärkers angeordnet ist.

3. Demodulator nach Anspruch 1, dadurch gekennzeichnet, daß das die Mischstufe (10) zwei Differential-Ausgänge besitzt und das Schleifenfilter (11) aus einem Verstärker mit unendlich hoher Verstärkung besteht, dessen Eingänge mit den Ausgängen der Mischstufe (10) über zwei Widerstände (R1, R1') verbunden sind, wobei ein RC-Glied (20) zwischen dem ersten Eingang und Masse und ein weiteres RC-Glied (20') zwischen dem zweiten Eingang und dem Ausgang des Verstärkers angeordnet ist.

4. Demodulator nach einem beliebigen der Ansprüche 2 oder 3, dadurch gekennzeichnet, daß jedes RC-Glied (20, 20') auf drei parallelen Zweigen enthält:

   - einen ersten Widerstand (R4, R4') des Werts Ra,

- einen zweiten Widerstand (R3, R3') des Werts Rb in Reihe mit einem Kondensator (C; C'),

einen dritten Widerstand (R2, R2') des Werts Rc in Reihe mit einem elektrisch steuerbaren Schalter (21; 21'), der als Steuersignal das Ausgangssignal (LS) der Schaltung (13) zur Erfassung des Einrastens des VCO erhält,
      wobei gilt: Ra >> Rc >> Rb.

**5.** Demodulator nach Anspruch 1, dadurch gekennzeichnet, daß die Erfassungsschaltung (13) für das Einrasten des VCO einen ersten Koppler (15) an das Eingangssignal und einen zweiten Koppler (16) an das Schleifensignal am Ausgang des VCO (12) enthält, wobei die beiden Koppler (15, 16) direkt bzw. über einen $\pi/2$-Phasenschieber (17) mit einer Mischstufe (18) verbunden sind, deren Ausgang ein Verriegelungssignal (LS) liefert.


**Claims**

**1.** Phase-locked loop demodulator comprising a loop filter (11) and a VCO (12), said loop filter comprising an amplifier (19) to provide loop gain and at least one selectively operable switch (21), said switch (21) modifying said loop gain by operating on the characteristics of said filter (11), **characterised in that** said demodulator further comprises at least one mixer (10) and one lock-on detector circuit (13), said detector circuit supplying an output signal (LS) to said selectively operable switch (21) to increase the loop gain by operating on the characteristics of said filter (11) when lock-on is detected.

**2.** Demodulator according to claim 1 characterised in that the loop filter (11) is an infinite gain amplifier (19) having one input earthed and the other input connected to the output of the mixer (10) through a resistor (R1), an RC network (20) being connected between said second input and the output of the amplifier.

**3.** Demodulator according to claim 1 characterised in that the mixer (10) has two differential outputs and in that the loop filter (11) is an infinite gain amplifier the inputs of which are connected to the outputs of the mixer (10) through two resistors (R1, R1'); two networks (20, 20') being provided, one between the first input and earth and the other between the second input and the output of the amplifier.

**4.** Demodulator according to claim 2 or claim 3 characterised in that each network (20, 20') comprises in three parallel branches:

- a first resistor (R4, R4') having a resistance of Ra;
- a seonc resistor (R3, R3') having a resistance of Rb in series with a capacitor (C, C'), and
- a third resistor (R2, R2') having a resistance Rc in series with an electrically controlled switch (21, 21') controlled by the output signal (LS) of the lock-on detector (13);
      with Ra >> Rc >> Rb.

**5.** Demodulator according to claim 1 characterised in that the lock-on detector circuit (13) comprises a first coupler (15) adapted to sample the input signal and a second coupler (16) adapted to sample the loop signal at the output of the VCO (12), said two couplers (15, 16) being respectively connected directly and through a $\pi/2$ phase-shifter (17) to a mixer (18) whose output supplies a locking signal (LS).

# FIG.1

# FIG.2